(19) Europäisches Patentamt
European Patent Office
Office européen des brevets

(11) **EP 3 806 260 A1**

(12) **EUROPEAN PATENT APPLICATION**

(43) Date of publication:
**14.04.2021 Bulletin 2021/15**

(51) Int Cl.:
***H02J 3/00*** (2006.01) ***G01R 31/00*** (2006.01)
***H02H 11/00*** (2006.01)

(21) Application number: **19306316.1**

(22) Date of filing: **08.10.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Netatmo**
**92100 Boulogne Billancourt (FR)**

(72) Inventors:
• **ESNAULT, Frédéric**
**78960 VOISINS-LE-BRETONNEUX (FR)**
• **CAZALIS, Romain**
**78220 VIROFLAY (FR)**

(74) Representative: **Marks & Clerk France**
**Immeuble "Visium"**
**22, avenue Aristide Briand**
**94117 Arcueil Cedex (FR)**

(54) **PHASE LINE AND NEUTRAL DETECTION CIRCUIT**

(57) The invention relates to electrical circuits. More specifically, the invention relates to the detection whether an input wire is floating, connected to the Line or to the Neutral of an AC electric power supply. The invention uses impedances between a point of the circuit and the Input, the Line and the Neutral, and the status of the input line is determined based on the voltage at said point of the circuit, or a derivative thereof.

FIG.3

EP 3 806 260 A1

**Description**

FIELD OF THE INVENTION

The present invention relates to the field of electric circuitry. More specifically, it relates to the detection of a type of input line, between a floating input, a connection to a Line or Neutral of an AC power supply.

BACKGROUND PRIOR ART

Electric power supply is generally provided through AC power supply. Household power is usually provided through single-phase electric power using at least two wires:

- a line wire (which may also be called phase, hot, or active contact) carries alternating current between power grid and the household;
- a neutral wire also carries AC current, and remains at a voltage around 0V. It may be connected to the ground or Earth.

Additionally, an Earth wire, or ground, may be present to protect a device against faults or electric shocks.
One general challenge of many wall-powered electronic systems consists in detecting whether a wire is connected to line or neutral. Indeed, such device may let the current pass or not depending whether an input is connected to Line or Neutral wire. For example, a hot water boiler may be turned on only if an AC line signal is detected. The detection of input type is thus crucial.

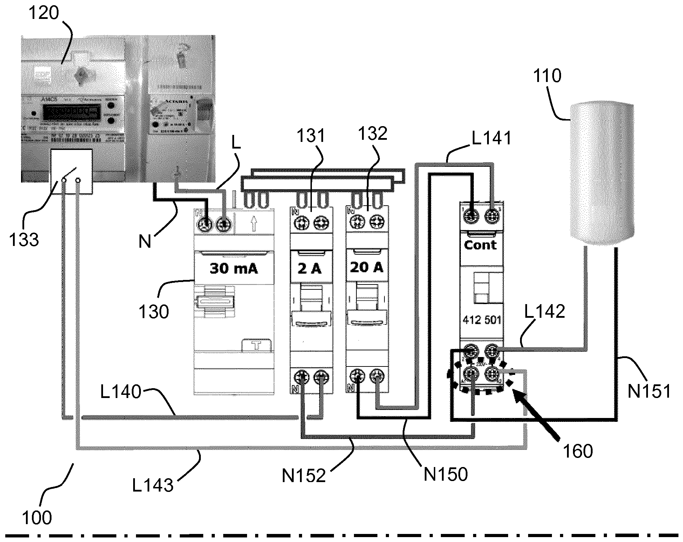

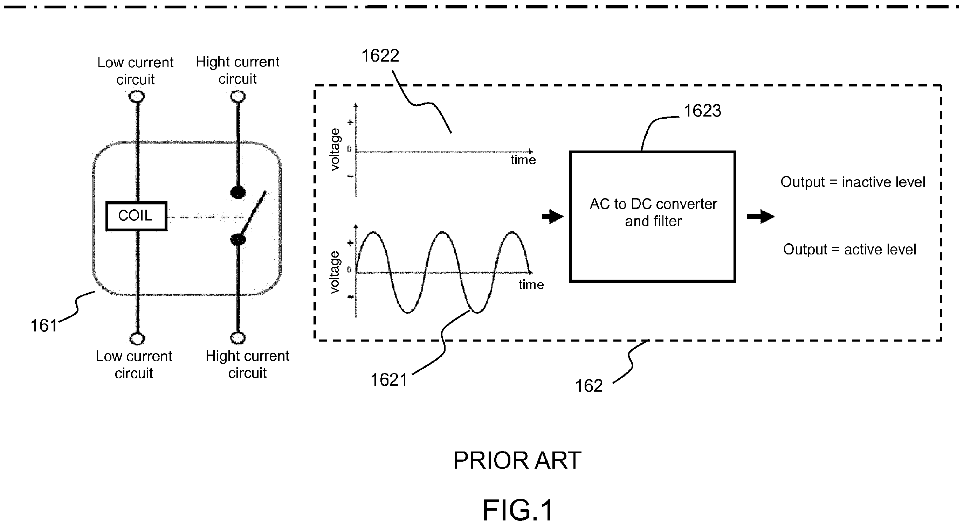

Figure 1 represents a circuit that detects if an input line is a line or a neutral in the prior art.
A device is connected to an AC electric power supply through an electric panel 120 granting access to the Neutral wire N, and Line wire L. The wires go through a plurality of circuit breakers 130, 131, 132: the line wire L is connected to wires L140, L141, L 142. A power switch 133 allows or not the connection of wire L140 (and thus Line wire L) to the line L143. The Neutral wire N is connected, through the circuit breakers, through wires N150, N151, N152.
An input command detector 160 detects, based on current in wire L143, whether the switch 133 is ON or OFF. At the output of wires L143 and N152. Based on this detection, it lets or not the current flow from wires L141 and N150 to wires L142 and N151 respectively, and power or not the device 110.
In prior art systems, the AC Line detection is performed by providing directly AC line to the coil of a relay. Figure 1 also displays two kinds of prior art AC line detectors:

- the detector 161 comprises a mechanical relay wherein the input powers a relay coil. When the coil is powered, an AC line input is detected;
- the detector 162 is a digital detector: the input is converted to direct current by the converter 1623, and provided to a digital detector. If the input is AC line, an oscillating voltage 1621 is detected by the digital detector. Otherwise a near null voltage 1622 is detected.

Such prior art circuits are able to detect whether AC line is connected. They however suffer a number of drawbacks. For example:

- they are not able to detect in the same time line an neutral connection conditions;
- they are complex and power consuming;
- they take space;
- some detectors, such as mechanical relays are not compatible with all environments. For example, coils may produce electromagnetic interferences that may pollute surrounding electronics.

There is therefore the need of a simple, compact and low power circuit which is able to detect both Line and Neutral wires connection conditions.

SUMMARY OF THE INVENTION

To this effect, the invention discloses an electric circuit comprising: a connection to the Line of an AC electric power supply; a connection connecter to the Neutral of said AC electric power supply; an input wire configured to be floating, connected to said Line, or to said Neutral ; a first impedance, a second impedance, and a third impedance, said first, second, and third impedance being placed between a first point and, respectively, the Line, the Neutral and the input wire; at least one processing logic; wherein said processing logic is configured to determine whether the input wire is floating, connected to said Line, or to said Neutral based on the voltage at said first point, or a derivative thereof.

Advantageously, the electric circuit further comprises at least one filter configured to apply at least one transfer function between the first point and a first input of the processing logic.

Advantageously, said at least one transfer function is designed to adapt the voltage at the first input of the processing logic to an input voltage which is usable by the processing logic.

Advantageously, said at least one transfer function comprises one or more transfer function chosen in a group comprising a voltage normalization, a clamping, a RMS voltage conversion, and an AC to DC conversion.

Advantageously, the filter is configured to apply a transfer function to transform a voltage at the first point to a voltage at the first input of the processing logic that is equal to or below an input voltage limit of the processing logic.

Advantageously, the values of Z1, Z2 and Zi are selected, so that the voltage at said first point, or derivative thereof at said first point has a value belonging respectively to three ranges if the input wire is floating, connected to said Line, or to said Neutral; the processing logic is configured to determine whether the input wire is floating, connected to said Line, or to said Neutral by verifying to which of the three non-overlapping ranges belongs the voltage, or derivative thereof.

Advantageously, the electric circuit comprises: a fourth impedance between the Line and a second point; a fifth impedance between the Neutral and the second point; and wherein: the processing logic is configured to determine whether the input wire is floating, connected to said Line, or to said Neutral based on: the voltage at said first point, or a derivative thereof, and the voltage at said second point, or a derivative thereof.

Advantageously, the processing logic is configured to determine whether the input wire is floating, connected to said Line, or to said Neutral based on a ratio between the voltage at the first input point of the processing logic, and the voltage at the second input point of the processing logic.

Advantageously, the first impedance is equal to the fourth impedance, and the second impedance is equal to the fifth impedance, and wherein the processing logic is configured to determine if the ratio between the voltage at the first input point and the voltage at the second input point of the processing logic belongs to a first, a second and a third non-overlapping range, and wherein the processing logic is configured to determine that the input wire is: floating, if the ratio belongs to the first non-overlapping range, comprising the value 1; connected to Line, if the ratio belongs to the second non-overlapping range, comprising the value $\left| \dfrac{(Z1+Zi)(Z1+Z2)}{(Z1+Zi)(Z1+Z2)-Z1^2)} \right|$; connected to Neutral, if the ratio between the voltage at the first input point and the voltage at the second input point of the processing logic belongs to the third non-overlapping range, comprising the value $\left| \dfrac{(Zi(Z1+Z2))}{(Zi(Z1+Z2)+Z1*Z2)} \right|$.

Advantageously, the processing logic is further configured to: determine the status of a command of an electric device based on the status of the input wire; send said command to said electric device.

Advantageously, said electric device is chosen in a group comprising one or more of smart appliances, smart plugs, shutters, heating devices, cooling devices, ventilation systems, blinders, windows, sensors, home or building management devices.

The invention also discloses a method comprising : receiving a voltage at a first point of an electric circuit, or a derivative thereof, said electric circuit comprising: a connection to the Line of an AC electric power supply; a connection connecter to the Neutral of said AC electric power supply; an input wire configured to be floating, connected to said Line, or to said Neutral ; a first impedance, a second impedance, and a third impedance, said first, second, and third impedance being placed between the first point and, respectively, the Line, the Neutral and the input wire; determining whether the input wire is floating, connected to said Line, or to said Neutral based on the voltage at said first point, or a derivative thereof.

The invention also discloses a computer program product comprising computer code instructions configured to receive a voltage at a first point of an electric circuit, or a derivative thereof, said electric circuit comprising: a connection to the Line of an AC electric power supply; a connection connecter to the Neutral of said AC electric power supply; an input wire configured to be floating, connected to said Line, or to said Neutral ; a first impedance, a second impedance, and a third impedance, said first, second, and third impedance being placed between the first point and, respectively, the Line, the Neutral and the input wire; determine whether the input wire is floating, connected to said Line, or to said Neutral based on the voltage at said first point, or a derivative thereof.

BRIEF DESCRIPTION OF THE DRAWINGS

The invention will be better understood and its various features and advantages will emerge from the following description of a number of exemplary embodiments provided for illustration purposes only and its appended figures in which:

- Figure 1 represents a circuit that detects if an input line is a line or a neutral in the prior art;
- Figure 2 displays a light switching module in which the invention may be implemented;

- Figure 3 displays an example of line and neutral detection circuit in a number of embodiments of the invention;
- Figure 4 displays an example of non-overlapping ranges of voltage ratios depending upon the state of the input wire;
- Figure 5 displays an example of line and neutral detection circuit in an embodiment of the invention using a single ADC input;
- Figure 6 displays three examples of ADC inputs in an embodiment of the invention, when the input line is respectively floating, connected to line and connected to neutral;
- Figure 7 displays an example of line and neutral detection circuit in an embodiment of the invention using two ADC inputs;
- Figure 8 displays an example of method in a number of embodiments of the invention.

DETAILED DESCRIPTION OF THE INVENTION

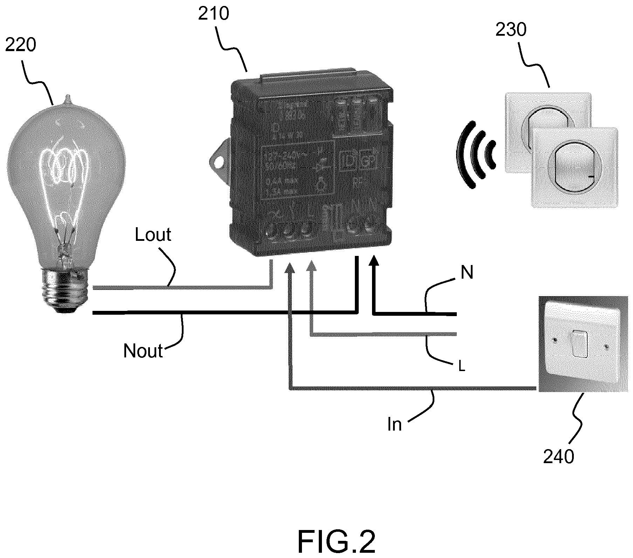

Figure 2 displays a light switching module in which the invention may be implemented.

The switching module 210 is connected to the Line L and Neutral N of an AC power supply. It is able to connect the Line L and Neutral N to a light switch through an output Line $L_{out}$, and Neutral $N_{out}$ to light on the switch, or block the current to light OFF the switch. To this effect, it may receive commands from wireless switches 230, or a wall mounted switch 240.

When the wall mounted switch is ON, the input line In is connected to the Line L. Otherwise, if the wall mounted switch is in the OFF position, the input line In is connected to Neutral, and the input In is floating when the product is not fully installed/connected. The module 210 should switch ON the light 220 only if the input In is connected to the Line L. This example is provided by means of example only of device in which the invention may be implemented. According to other embodiments of the invention, the device may be configured to detect if the input is connected to the Neutral N or floating. More generally, according to various embodiments of the invention, a device may be used to detect any combination of Line, Neutral and/or floating inputs.

Therefore, the switching module 210 is configured to detect if the input In is floating, connected to Line L or connected to Neutral N of the AC power supply, and switch the light ON or OFF accordingly.

As noted above, this is provided by means of example only, and the invention may be implemented in any device that is configured to detect if an input line is floating, connected to Line or connected to Neutral.

Moreover, the invention is more generally applicable to any device that detects a Line, Neutral and/or floating input, and determines the status of a 2 or 3 states command accordingly. For example, the invention may be used:

- for sending commands to shutters: a mechanical roller shutters switch (3 positions: up/stop/down) could thus be connected to the input of the device to trigger a up/stop/down action;
- for heating/cooling systems: a 3 states switch could be connected to the input of the device to trigger a heating/stop/cooling action to the device. It could also be used to control an electrical heater in different modes: for example stop/heating eco/heating max;
- for ventilation system: a 3 states switch could be connected to the input of the device to turn on-high-speed/on-low-speed/off a fan.

It can thus be appreciated that the disclosure provides a simple and efficient solution using the Line, Neutral and/or floating detection to generate a 2 or 3 state commands to various kinds of devices comprising smart appliances, smart plugs, shutters, environmental systems (heating, cooling, ventilation), blinders, windows, sensors, and other intelligent or connected home or building management devices. The invention is adaptable to the commands expected by virtually any device.

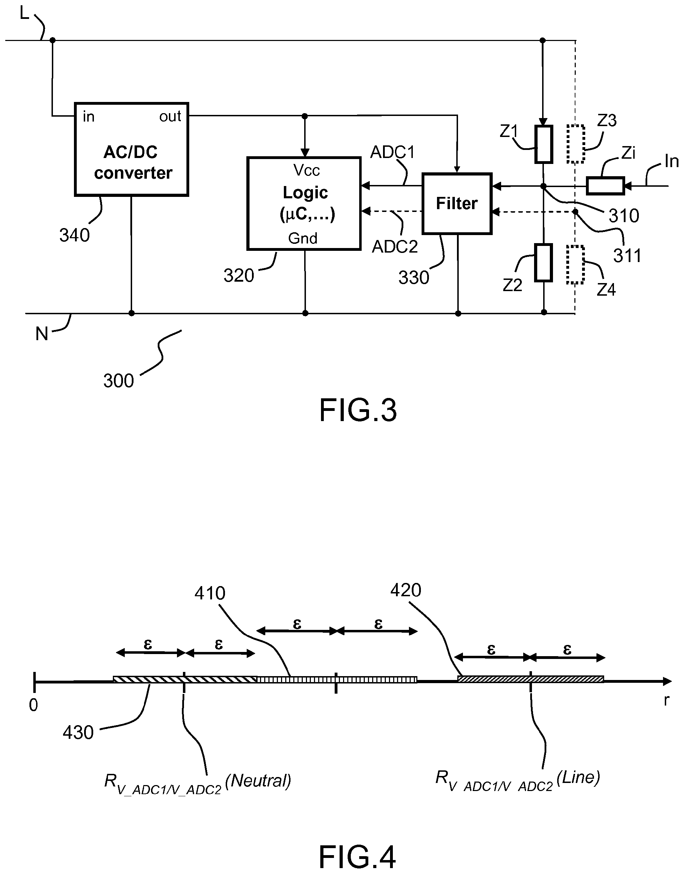

Figure 3 displays an example of line and neutral detection circuit in a number of embodiments of the invention.

The circuit 300 is connected to the Line L, and Neutral N of an AC power supply, and comprises an input line In which may be floating, or connected either to Line L or Neutral N. The input may be floating when it is not yet connected to the AC power supply, and connected to Line L or Neutral N otherwise.

The circuit 300 is configured to detect whether the input In is floating, connected to Line or connected to Neutral, based on the voltage at an input point 310, or a derivative thereof.

To this effect, the circuit 300 comprises:

- a first impedance Z1 between Line L and the input point 310;
- a second impedance Z2 between Neutral N and the input point 310;
- a third impedance Zi between Input In and the input point 310.

The impedances may be any combination of linear passive components such as for example resistors, capacitors, or a combination thereof.

The circuit 300 also comprises at least one processing logic 320. According to various embodiments of the invention, a processing logic may be a processor operating in accordance with software instructions, a hardware configuration of a processor, or a combination thereof. The processing logic may be based on, or run on very different hardware such as a processor, a microcontroller, a DSP (Digital Signal Processor), etc. It should be understood that any or all of the functions discussed herein may be implemented in a pure hardware implementation and/or by a processor operating in accordance with software instructions. It should also be understood that any or all software instructions may be stored in a non-transitory computer-readable medium. For the sake of simplicity, in the remaining of the disclosure the one or more processing logic will be called "the processing logic". However, it should be noted that the operations of the invention may also be performed in a single processing logic, or a plurality of processing logics, for example a plurality of processors.

The voltage at the input point 310 is therefore AC. In a number of embodiments of the invention, the circuit 300 comprises at least one filter 330. According to various embodiments of the invention, a single filter may be used, that executes one or more functions, or a plurality of filters may be used. For the sake of simplicity, in the present disclosure the at least one filters 330 will be represented as a single filter, and designated as "the filter". However, according to various embodiments of the invention this may represent a plurality of filters. According to various embodiments of the invention, the filter is configured at least to convert the AC voltage from input point 310 to a first input ADC1 of the processing logic 320.

In a number of embodiments of the invention, the filter is configured to apply at least one transfer function. The transfer function may be designed to adapt the voltage at the first input ADC1 of the processing logic to an input voltage which is usable by the processing logic. This allows the input logic to have as input a voltage that complies with the input range, and that can be used for determining the status of the input wire. For example, the transfer functions may comprise a transfer function to transform a voltage at the first point 310 to a voltage at the first input ADC1 of the processing logic that is equal to or below an input voltage limit of the processing logic. Such a filter may for example be a voltage divider.

Indeed, the voltages accepted as input by processing logics are usually lower than voltages of AC power supply. For example, AC power supply has a voltage of 230V RMS in France, which cannot be supplied as input to most of the processors. Therefore, such a transfer function reduces the voltage at the input of the processing logic 320 to a value which is accepted as input by the processing logic. Therefore, such a transfer function ensures that the input voltage of the processing logic does not exceed allowed range of input voltages of the processing logic, and thus prevent damages of the processing logic. This also allows ensuring that the voltages at the input of the processing logic are in a range that allows a proper detection of the input In.

The skilled man may without effort define suitable transfer functions depending on the maximum voltage of the AC power supply, and target maximum voltage at the input of the processing logic. The transfer functions may for example be non-linear functions, or voltage dividers.

The filter 330 may also apply a clamping function, for example to prevent the voltage to fall below 0V and /or above an input voltage of the processing logic.

In a number of embodiments of the invention, a transfer function is a RMS (Root Mean Square) function: the voltage at the first input ADC1 of the processing logic would thus be the RMS of the voltage at the first point 310. The use of the RMS functions allows. The filter 330 may execute a combination of the above defined transforms and/or other transform defined by the skilled man.

In a number of embodiments of the invention, the circuit 300 also comprises an AC/DC converter 340 to convert AC current from the AC power supply to direct current and power the processing logic 320, and in a number of embodiments, the filter 330.

The processing logic 320 is configured to determine whether the input wire In is floating, connected said Line, or connected to said Neutral based on the voltage at the first point 310, or a derivative thereof.

Indeed, the voltage at the first point 310 is dependent upon the state of input wire In (floating, connected to Line or connected to Neutral), and the values of the first impedance Z1, second impedance Z2, third impedance Zi, and of the voltage $V_i$ between the Line L and Neutral N, which is thus the voltage of the AC power supply.

The impedances act as voltage dividers, and the voltage $V_{input\_filter}$ at the first point, which is also the voltage at the input of the filter 330, is equal:

- when the input In is floating, to:

$$V_{input\_filter} = V_i * \frac{Z2}{Z1+Z2}$$

*(Equation 1)*

- when the input is connected to Line, to:

$$V_{input\_filter} = V_i * \frac{Z2\,(Z1+Zi)}{Z1*Zi+Z2*(Z1+Zi)}$$

*(Equation 2)*

- when the input is connected to Neutral, to:

$$V_{input\_filter} = V_i * \frac{Z2*Zi}{Z1*(Z2+Zi)+Z2*Zi}.$$

*(Equation 3)*

The processing logic is thus able, from the value of $V_{input\_filter}$ (or the value transformed by a transfer function in the filter 330) to detect to which condition corresponds the value of $V_{input\_filter}$. The circuit 300 therefore allows a simple and efficient solution to determine the state of the input wire In. The circuit 300 also overcomes the drawbacks of prior art systems: contrarily to prior art solutions, the circuit 300 is also able to detect in the same time floating, Line and Neutral conditions, without requiring extra wires, coils or relays. Thus, the circuit 300 takes less space, is less complex and power consuming than prior art solutions. Moreover, the lack of mechanical coils/relays, and the simplicity of the circuits renders it robust and adaptable to any kind of environment. For example, such a device does not create electromagnetic interference, and therefore has a good Electro Magnetic Compatibility (EMC).

Moreover, in a number of embodiments of the invention, the processing logic is able to determine from said status of the input wire the state of a command of a device, and send said command. This can be performed using a simple mapping between the state of the input wire and the command of the device. For example:

- if the device is a mechanical roller shutters switch with 3 positions up/stop/down, each of the 3 states of the input wire can be associated with each of the positions of the roller shutters, and, when the state of the input wire is obtained, the processing logic can determine the corresponding command and send it to the roller shutters;
- if the device is electrical heater with different modes, for example stop/heating eco/heating max, each of the 3 states of the input wire can be associated with each of the modes of the electrical heater, and, when the state of the input wire is obtained, the processing logic can determine the corresponding command and send it to the electrical heater;
- if the device is a ventilation system having three speeds of operation (highspeed/low-speed/off), each of the 3 states of the input wire can be associated with each of the speeds of the fan, and, when the state of the input wire is obtained, the processing logic can determine the corresponding command and send it to the fan.

It can thus be appreciated that the status of the input wire can be used to determine the commands of virtually any device or appliance that accepts a 3 or 2 states commands as input. Indeed, if in the previous examples commands with 3 states were used (in such case each of the Line, Neutral, floating is associated to a different command), 2-states commands, such as an ON/OFF command of a lighting device may be used as well. In such cases, two of the states of the input wire may be associated to the same command, or one of the possible states of the input wire may not be associated to any command.

The electric circuit of the invention therefore provides a simple and convenient solution to command a wide number of different appliances accepting various inputs. Moreover, the electric circuit can be adapted easily to different devices or commands: the association between the status of the input wire and the commands can be modified using a simple update, without needing to modify the detection of the status of the input wire.

The commands may either be sent permanently (for example by letting or not current flow to a device such as a lighting device), or upon a change of the status of the input wire (for example by sending a command to start/stop the operation of a fan upon a change of the status of the input wire.

The determination of the state of the input wire In based on the voltage at the first point 310, or derivative thereof, may be performed according to different rules. For example, it may determine, from an input voltage, if the closest voltage is the one corresponding to a floating, Line or Neutral input.

In a number of embodiments of the invention, the values of Z1, Z2 and Zi are selected so that the voltage $V_{input\_filter}$ at the first point 310, and thus the voltage at the first input ADC1 of the processing logic are respectively in three overlapping ranges if the input wire In is floating, connected to Line or connected to Neutral. The processing logic 320 can thus be configured to determine the state of the input wire In by verifying in which if the three non-overlapping ranges lies the first input ADC1.

This provides a simple and efficient solution to determine what is the state of the input wire In. Moreover, this allows ensuring that there will be no ambiguity regarding the state of the input wire, because the ranges do not overlap, and a voltage can be associated without ambiguity to a state of the input wire.

The skilled man can thus, based on the voltage of the AC power supply, or ranges of voltages of the AC power supply if it is slightly modified over time, determine corresponding values of Z1, Z2 and Zi that allow obtaining three non-overlapping ranges.

However, this determination may be rendered more difficult in cases wherein the voltage of the AC power supply is not known in advance. This is for example the case for products that may be sent in an identical version worldwide. Indeed, the voltage of the AC power supply is different in various world regions. For example, the voltage of mains electricity is 230V in Europe, but 220V in China and many African countries, 120 V in North America, 110V in Venezuela... If the voltage of the AC power supply can be determined for a given region, it cannot be known in advance if the circuit is intended to be used in different regions worldwide. Even in the same region, the AC power supply voltage may be slightly different than the nominal voltage. For example, in an area wherein the voltage is supposed to be 230 V RMS, it may in practice vary between 220 and 240 V RMS. In such cases, the voltage at the first point 310 depends on the state of the input wire In, but also of the voltage between Line and Neutral, which is not known a priori.

In order to provide a deterministic determination of the state of the input wire In when the voltage between Line and Neutral is not known a priori, or varies around a nominal value, in a number of embodiments of the invention, the circuit 300 comprises:

- a fourth impedance Z3 between the Line and a second point 311;
- a fifth impedance Z4 between the Neutral and the second point.

In such embodiments, the filter 330 is also configured at least to transform AC to DC current between the second point 311 and a second input ADC2 of the processing logic. In embodiments wherein the filter 330 is also configured to apply a function to transform the voltage at the first point 310 to a voltage at the first input ADC1, the filter 330 is also configured to apply the same transfer function to transform the voltage at the second point 311 to a voltage at the second input ADC2.

Therefore, the processing logic 320 is configured to determine whether the input wire In is floating, connected to said Line, or to said Neutral based on both the voltage at said first point 310, or a derivative thereof, and the voltage at said second point 311, or a derivative thereof. For example, the processing logic 320 may be configured to determine the status of the input wire In based on the voltages at the first input point ADC1, and the second input point ADC2, as transformed by the filter.

This allows determining the status of the input wire even if the voltage between the Line and Neutral is a priori unknown. Indeed, the voltage at the second point 311, and thus the voltage at the second input point ADC2 depend only on the voltage between Line and Neutral.

More specifically, the voltage $V_{input\_filter\_2}$ at the second point 311 is equal to:

$$V_{input\_filter\_2} = \boldsymbol{V_i} * \frac{Z4}{Z3+Z4}$$

*(Equation 4)*

Thus, the voltage $V_i$ between Line and Neutral can be directly retrieved from the voltage $V_{input\_filter\_2}$ at the second point 311 (or from the voltage at the second input ADC2 of the processing logic). This determination of the voltage between Line and Neutral in turn allows adapting the determination of input wire status based on the voltage at the first point 310, or at the first input ADC1 of the processing logic. For example, if the determination is based on three non-overlapping ranges, the bounds of the range may be expressed as a function of Vi, and adapted based on the determination of Vi explained above.

The status of the input wire may also be determined directly based on a ratio $R_{V\_ADC1/V\_ADC2}$ between the voltages $V_{ADC1}$ at the first input ADC1, and $V_{ADC2}$ at the second input ADC2 of the processing logic 320. This allows a simple and efficient way of determining the status of the input wire.

Figure 4 displays an example of non-overlapping ranges of voltage ratios depending upon the state of the input wire.

In a number of embodiments of the invention, the fourth impedance Z3 is equal to the first impedance Z1, and the fifth impedance Z4 is equal to the second impedance Z2. It shall be noted that here "equals" means "substantially equal", that is to say that the values of impedance may actually have very small differences, which are inherent to the construction of the impedance.

In a number of embodiments of the invention, the circuit comprises the filter 330 that performs the same transfer function to transform the voltage at the first input point 310 into the voltage $V_{ADC1}$ at the first input of the processing logic, and the voltage at the second input point 311 into the voltage $V_{ADC2}$ at the second input ADC2 of the processing logic. Therefore, the ratio $R_{V\_ADC1/V\_ADC2}$ between the voltage $V_{ADC1}$ at the first input of the processing logic, and the voltage $V_{ADC2}$ at the second input ADC2 of the processing logic is a function of the ratio of the voltages between at the first input point 310, and the second input point 311. If the transfer function is a linear function, the two ratios are equal. Provided that Z1 = Z3, and Z2 = Z4, it is possible to express the ratio as a function of Z1, Z2 an Zi depending upon the state of the input wire, as will be expressed below.

If the input In is floating, we have:

$$R_{V\_ADC1/V\_ADC2}(\text{Floating}) = 1$$

*(Equation 5)*

If the input In is connected to Line L, we have:

$$R_{V\_ADC1/V\_ADC2}(\text{Line}) = \left| \frac{(Z1+Zi)(Z1+Z2)}{(Z1+Zi)(Z1+Z2)-Z1^2)} \right| > 1$$

*(Equation 6)*

Wherein the operator | | represents the module of the expression inside the two "|" signs.

If the input In is connected to Neutral N, we have:

$$R_{V\_ADC1/V\_ADC2}(\text{Neutral}) = \left| \frac{(Zi(Z1+Z2))}{(Zi(Z1+Z2)+Z1*Z2)} \right| < 1$$

*(Equation 7)*

The use of Z1=Z3, and Z2=Z4 therefore allows to have three different values of the ratio, whatever the values of Z1, Z2 and Zi. The processing logic can thus be configured to detect the status of the input wire, by verifying if the ratio $R_{V\_ADC1/V\_ADC2}$ is in one of three non-overlapping ranges, the status being:

- floating, if $R_{V\_ADC1/V\_ADC2}$ is in a range comprising the value

$$R_{V\_ADC1/V\_ADC2}(\text{Floating}) = 1;$$

- connected to Line L, the $R_{V\_ADC1/V\_ADC2}$ is in a range comprising the value

$$R_{V\_ADC1/V\_ADC2}(\text{Line}) = \left| \frac{(Z1+Zi)(Z1+Z2)}{(Z1+Zi)(Z1+Z2)-Z1^2} \right|;$$

- connected to Neutral N, the $R_{V\_ADC1/V\_ADC2}$ is in a range comprising the value $$R_{V\_ADC1/V\_ADC2}(\text{Neutral}) = \left| \frac{(Zi(Z1+Z2))}{(Zi(Z1+Z2)+Z1*Z2)} \right|.$$

In a number of embodiments of the invention, the three non-overlapping ranges are defined by adding a margin ε around central values, which are respectively $R_{V\_ADC1/V\_ADC2}(\text{Floating})$, $R_{V\_ADC1/V\_ADC2}(\text{Line})$ and $R_{V\_ADC1/V\_ADC2}(\text{Neutral})$.

In the non-limitative example of Figure 4, the margin ε is equal to 0,5 * (min($R_{V\_ADC1/V\_ADC2}(\text{Line})$ - $R_{V\_ADC1/V\_ADC2}(\text{Floating})$ ; $R_{V\_ADC1/V\_ADC2}(\text{Floating})$ - $R_{V\_ADC1/V\_ADC2}(\text{Neutral})$)), in order to have the largest possible margin that produces non-overlapping ranges.

This therefore results in three non-overlapping ranges, the status of the input wire being detected as:

- floating, if $R_{V\_ADC1/V\_ADC2}$ is in the first range 410 : ] $R_{V\_ADC1/V\_ADC2}$(Floating) - $\varepsilon$; $R_{V\_ADC1/V\_ADC2}$(Floating) + $\varepsilon$ [;
- connected to Line, if $R_{V\_ADC1/V\_ADC2}$ is in the second range 420: ]$R_{V\_ADC1/V\_ADC2}$(Line) - $\varepsilon$; $R_{V\_ADC1/V\_ADC2}$(Line) + $\varepsilon$ [;
- connected to Neutral, if $R_{V\_ADC1/V\_ADC2}$ is in the third range 430: ]$R_{V\_ADC1/V\_ADC2}$(Neutral) - $\varepsilon$; $R_{V\_ADC1/V\_ADC2}$(Neutral) + $\varepsilon$ [.

However, these examples are provided by means of example only, and any combination of non-overlapping ranges comprising respectively the values $R_{V\_ADC1/V\_ADC2}$(Floating), $R_{V\_ADC1/V\_ADC2}$(Line) and $R_{V\_ADC1/V\_ADC2}$(Neutral) may be used in a number of embodiments of the invention.

These examples demonstrate that, in certain embodiments of the invention, the circuit allows a simple and efficient detection of the status of the input wire based on the ratio $R_{V\_ADC1/V\_ADC2}$, which is not dependent upon the voltage of the AC power supply, and can thus be used with any power source.

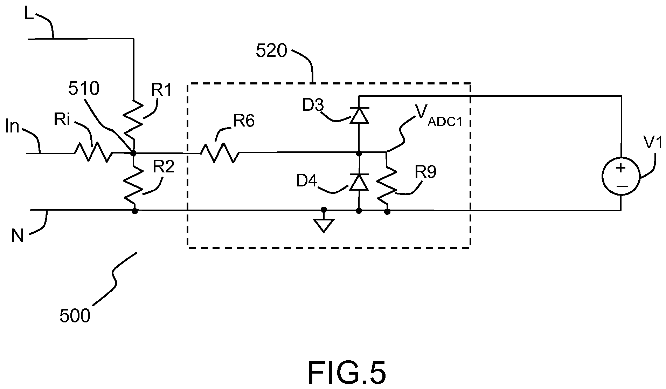

The figure 5 displays an example of line and neutral detection circuit in an embodiment of the invention using a single ADC input.

The circuit 500 is an example of circuit of the invention. The circuit 500 comprises a connection to Line L, Neutral N, and an input wire In which may be floating, connected to Line L, or connected to Neutral N. The circuit 500 is specifically tailored to operate around a nominal 230V 50 HZ voltage.

The determination of the status of the input wire In is determined based on the voltage at a first point 510. The circuit comprises:

- a first impedance R1 between the first point 510 and the Line L. The impedance R1 is in this example a resistor having a resistance of 150 K$\Omega$;
- a second impedance R2 between the first point 510 and the Neutral N. The impedance R2 is in this example a resistor having a resistance of 68 K$\Omega$;
- a third impedance Ri between the first point 510 and the input In. The impedance Ri is in this example a resistor having a resistance of 68 k$\Omega$.

The filter 520 is made of:

- two resistors R6, R9. R6 has a resistance of 220 k$\Omega$, and R9 a resistance of 4,7 k$\Omega$;
- two clamping diodes D3, D4.

The processing logic, not represented here, determines the status if the input wire In based on the voltage $V_{ADC1}$ at the output of the filter, which derives from the voltage at the first point 510.

The filter 520 therefore has two functions:

- it performs a voltage division through the resistors R6 and R9, that divide the voltage by (220+4,7)/4,7 = 47,8. The nominal voltage of the AC power supply being here 230V, the voltage at the output of the filter is approximately thus up to 4,9, which is compliant with the possible inputs of the processing logic;
- it rectifies the current through the diodes D3, D4: the current at the input of the processing logic is a direct current, and not an alternating one.

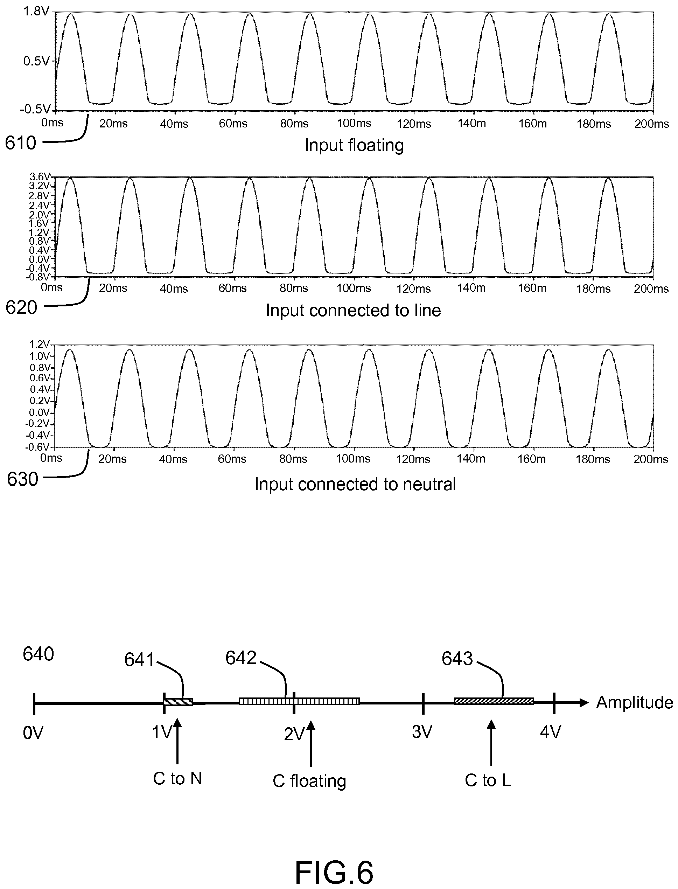

Figure 6 displays three examples of ADC inputs in an embodiment of the invention, when the input line is respectively floating, connected to line and connected to neutral.

In an experiment, the circuit 500 has been tested: the voltage over time has been measured at the first input ADC1 of the processing logic, when the input wire In was floating, connected to Line, connected to Neutral.

The curve 610 shows the voltage at the first input ADC1 of the processing logic, when the input is floating; the curve 620 shows the voltage at the first input ADC1 of the processing logic, when the input is connected to Line; curve 630 shows the voltage at the first input ADC1 of the processing logic, when the input is connected to Neutral. For all these curves, the voltage is indicated in the scale on the left of the curve. This shows that the voltage has different values depending upon the state of the input wire: 1,75 V when the input is floating, 3,59 V when it is connected to Line, and 1,11V when connected to Neutral.

This experiment has been extended, by varying the AC power supply voltage between 210, 230 and 250 V, and adding a capacitor between Line and Neutral, with a capacity of 0 nF, or 50 nF. This capacitor represents a parasitic coupling between electrical lines, which is a common situation in houses with long coupled parallel lines. This is a parasitic effect that can disturb electronics in other detection systems. The results are summarized in the table below:

| Input Capacity | AC Input Voltage | $V_{ADC1}$ Neutral | $V_{ADC1}$ Floating | $V_{ADC1}$ Line |
|---|---|---|---|---|
| 0 nF | 210 | 1,01 | 1,59 | 3,24 |
| | 230 | 1,11 | 1,75 | 3,59 |
| | 250 | 1,22 | 1,92 | 3,84 |
| 50 nF | 210 | 1,01 | 2,09 | 3,24 |
| | 230 | 1,11 | 2,31 | 3,59 |
| | 250 | 1,22 | 2,52 | 3,84 |

This table shows, for each combination of input capacity (0 nF: lines 2-4; 50 nF: lines 5-7), and AC Input Voltage (210 V: lines 2 and 5; 230 V: lines 3 and 6; 250 V: lines 4 and 7), the value of voltage $V_{ADC1}$ at the first input of the processing logic, when the input wire is connected to Neutral (colomn 3), floating (column 4), and connected to Line (column 5). The line 640 shows the ranges of voltage at the first input point of the processing logic in the test conditions. The table above shows that, under these test conditions, the voltage $V_{ADC1}$ is comprised in one the following ranges:

- range 641: 1,01 to 1,22 V when the input is connected to Neutral;
- range 642: 1,59 to 2,52V when the input is floating;
- range 643: 3,24 to 3,84 when the input is connected to Line.

This example demonstrates that it is possible, at least under reasonable assumptions of AC input voltage, to pre-define thresholds on the voltage $V_{ADC1}$ to determine the status of the input wire. For example, the processing logic may be configured to detect that the input wire is connected to Neutral, floating or connected to Line if the voltage $V_{ADC1}$ is in one of the ranges 641, 642 or 643 respectively.

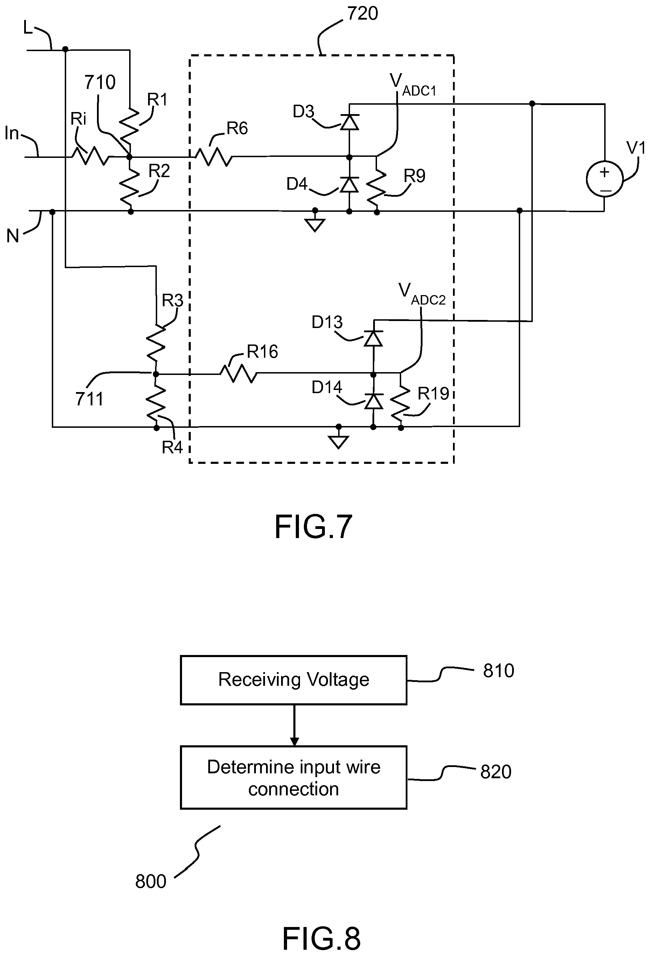

Figure 7 displays an example of line and neutral detection circuit in an embodiment of the invention using two ADC inputs.

The circuit 700 comprises all the elements of the circuit 500. The resistors have the same resistances as in the circuit 500, except R9 that has here a resistance of 3,9 kΩ. The first point is here noted 710 instead of 510, and the voltage at the first input point of the processing logic is still noted $V_{ADC1}$.

In addition, a second point 711 is defined, a fourth resistor R3 is placed between the Line and the second point 711, and a fifth resistor R4 is placed between the Neutral and the second point 711. The fourth resistor R3 has the same resistance than the first resistor R1: 150 KΩ, and the fifth resistor R4 has the same resistance than the second resistor R2: 68 KΩ.

The same filter 720 is applied to the voltages at the first point 710 and at the second point 711. As already discussed with reference to figure 5, the current is rectified, and the voltage divided between the voltage at the first point 710, and at the first input ADC1 of the processing logic.

The filter 720 is also configured to perform the same operations between the second point 711, and the second input point of the processing logic, wherein the voltage $V_{ADC2}$ is measured:

- the resistors R16 and R19 respectively have the same capacities than the resistors R6 and R9. The same voltage division is thus performed between the voltage in the first point 710 and the first input point of the processing logic ADC1 on one hand, and the second point 720 and the second input point of the processing logic ADC2 on the other hand;
- the diodes D13 and D14 rectify the alternative current into a direct current at the second input point ADC2 of the processing logic.

Therefore, the ratio between the voltages $V_{ADC1}$, and $V_{ADC2}$ is equal to the ratio between the voltages at the first point 710, and the second point 711, and, provided that R1 = R3, and R2 = R4, the status of the input line In can be determined based only on the ratio between $V_{ADC1}$ and $V_{ADC2}$ and the values of R1, R2 and Ri, whatever the AC power supply voltage, as already demonstrated with reference to figure 3.

It shall be noted that other values of R3 and R4 also allow determining the status of the input wire based on the ratio between $V_{ADC1}$ and $V_{ADC2}$. However such examples have not been developed yet for the sake of simplicity, the corresponding formulas being more complicated.

In addition, other filters than the filter 720 may be used, provided that the filter allows transforming AC into DC, and that, if the filter modifies the voltage between the first point 710 and the first input ADC1 of the processing logic, and between the second point 711 and the second input ADC2 of the processing logic, the correspondence between the voltages can be determined.

These examples demonstrate the ability of the invention to detect the status of an input wire, even in case of parasitic couplings.

Figure 8 displays an example of method in a number of embodiments of the invention.

The method 800 comprises a first step 810 of receiving a voltage at a first point of an electric circuit such as one of the circuits 300, 500, 700, or a derivative thereof.

The method comprises a second step 820 of determining whether the input wire is floating, connected to said Line, or to said Neutral based on the voltage at said first point, or a derivative thereof.

All the embodiments discussed above are respectively applicable to the method 800.

The examples described above are given as non-limitative illustrations of embodiments of the invention. They do not in any way limit the scope of the invention which is defined by the following claims.

**Claims**

1. An electric circuit (300, 500, 700) comprising:

   - a connection (L) to the Line of an AC electric power supply;
   - a connection (N) connecter to the Neutral of said AC electric power supply;
   - an input wire (In) configured to be floating, connected to said Line, or to said Neutral;
   - a first impedance (Z1, R1), a second impedance (Z2, R2), and a third impedance (Zi, Ri), said first, second, and third impedance being placed between a first point (310, 510, 710) and, respectively, the Line (L), the Neutral (N) and the input wire (In);
   - at least one processing logic (320, 420, 620);

   wherein said processing logic (320, 520, 720) is configured to determine whether the input wire (In) is floating, connected to said Line, or to said Neutral based on the voltage ($V_{input\_filter}$) at said first point (310, 510, 710), or a derivative thereof.

2. The electric circuit of claim 1, further comprising at least one filter (330, 530, 730) configured to apply at least one transfer function between the first point (310, 510, 710) and a first input (ADC1) of the processing logic.

3. The electric circuit of claim 2, wherein said at least one transfer function is designed to adapt the voltage at the first input (ADC1) of the processing logic to an input voltage which is usable by the processing logic.

4. The electric circuit of claim 3, wherein said at least one transfer function comprises one or more transfer function chosen in a group comprising a voltage normalization, a clamping, a RMS voltage conversion, and an AC to DC conversion.

5. The electric circuit of one of claims 2 or 4, wherein the filter is configured to apply a transfer function to transform a voltage at the first point to a voltage at the first input of the processing logic that is equal to or below an input voltage limit of the processing logic.

6. The electric circuit of one of claims 1 to 5, wherein:

   - the values of Z1, Z2 and Zi are selected, so that the voltage ($V_{input\_filter}$) at said first point, or derivative thereof at said first point has a value belonging respectively to three ranges (410, 420, 430, 641, 642, 643) if the input wire (In) is floating, connected to said Line, or to said Neutral;
   - the processing logic is configured to determine whether the input wire (In) is floating, connected to said Line, or to said Neutral by verifying to which of the three non-overlapping ranges belongs the voltage ($V_{input\_filter}$), or derivative thereof.

7. The electric circuit of one of claims 1 to 6, comprising:

   - a fourth impedance (Z3, R3) between the Line and a second point (311, 711);

- a fifth impedance (Z4, R4) between the Neutral and the second point;

and wherein:

- the processing logic is configured to determine whether the input wire (In) is floating, connected to said Line, or to said Neutral based on:

  ○ the voltage ($V_{input\_filter}$) at said first point, or a derivative thereof, and
  ○ the voltage at said second point, or a derivative thereof.

8. The electric circuit of claim 7, wherein the processing logic is configured to determine whether the input wire (In) is floating, connected to said Line, or to said Neutral based on a ratio between the voltage ($V_{ADC1}$) at the first input point (ADC1) of the processing logic, and the voltage ($V_{ADC2}$) at the second input point (ADC2) of the processing logic.

9. The electric circuit of claim 8, wherein the first impedance (Z1, R1) is equal to the fourth impedance (Z3, R3), and the second impedance (Z2, R2) is equal to the fifth impedance (Z4, Z4), and wherein the processing logic is configured to determine if the ratio ($R_{V\_ADC1/V\_ADC2}$) between the voltage at the first input point and the voltage at the second input point of the processing logic belongs to a first, a second and a third non-overlapping range, and wherein the processing logic is configured to determine that the input wire (In) is:

- floating, if the ratio ($R_{V\_ADC1/V\_ADC2}$) belongs to the first non-overlapping range (410), comprising the value 1;
- connected to Line (L), if the ratio ($R_{V\_ADC1/V\_ADC2}$) belongs to the second non-overlapping range (420), comprising the value $\left| \dfrac{(Z1+\bar{Z}i)(Z1+Z2)}{(Z1+Zi)(Z1+Z2)-Z1^2} \right|$;
- connected to Neutral (N), if the ratio ($R_{V\_ADC1/V\_ADC2}$) between the voltage at the first input point and the voltage at the second input point of the processing logic belongs to the third non-overlapping range (430), comprising the value $\left| \dfrac{(\bar{Z}i(Z1+Z2))}{(Zi(Z1+Z2)+Z1*Z2)} \right|$.

10. The electric circuit of one of claims 1 to 9, wherein the processing logic is further configured to:

- determine the status of a command of an electric device based on the status of the input wire;
- send said command to said electric device.

11. The electric circuit of claim 10, wherein said electric device is chosen in a group comprising one or more of smart appliances, smart plugs, shutters, heating devices, cooling devices, ventilation systems, blinders, windows, sensors, home or building management devices.

12. A method (800) comprising:

- receiving (810) a voltage ($V_{input\_filter}$) at a first point (310, 510, 710) of an electric circuit (300, 500, 700), or a derivative thereof, said electric circuit comprising:

  ○ a connection (L) to the Line of an AC electric power supply;
  ○ a connection (N) connecter to the Neutral of said AC electric power supply;
  ○ an input wire (In) configured to be floating, connected to said Line, or to said Neutral;
  ○ a first impedance (Z1, R1), a second impedance (Z2, R2), and a third impedance (Zi, Ri), said first, second, and third impedance being placed between the first point (310, 510, 710) and, respectively, the Line (L), the Neutral (N) and the input wire (In);

- determining (820) whether the input wire (In) is floating, connected to said Line, or to said Neutral based on the voltage ($V_{input\_filter}$) at said first point (310, 510, 710), or a derivative thereof.

13. A computer program product comprising computer code instructions configured to:

- receive a voltage ($V_{input\_filter}$) at a first point (310, 510, 710) of an electric circuit (300, 500, 700), or a derivative thereof, said electric circuit comprising:

    ◦ a connection (L) to the Line of an AC electric power supply;
    ◦ a connection (N) connecter to the Neutral of said AC electric power supply;
    ◦ an input wire (In) configured to be floating, connected to said Line, or to said Neutral;
    ◦ a first impedance (Z1, R1), a second impedance (Z2, R2), and a third impedance (Zi, Ri), said first, second, and third impedance being placed between the first point (310, 510, 710) and, respectively, the Line (L), the Neutral (N) and the input wire (In);

- determine whether the input wire (In) is floating, connected to said Line, or to said Neutral based on the voltage ($V_{input\_filter}$) at said first point (310, 510, 710), or a derivative thereof.

PRIOR ART

FIG.1

220 210 230

Lout

Nout

N

L

In

240

FIG.2

FIG.3

$R_{V\_ADC1/V\_ADC2}$ (Neutral)

$R_{V\ ADC1/V\ ADC2}$ (Line)

FIG.4

FIG.5

Input floating

Input connected to line

Input connected to neutral

FIG.6

FIG.7

FIG.8

Europäisches
Patentamt

European
Patent Office

Office européen
des brevets

# EUROPEAN SEARCH REPORT

Application Number

EP 19 30 6316

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2012/101347 A1 (PEUGEOT CITROEN AUTOMOBILES SA [FR]; MORAND NICOLAS [FR]) 2 August 2012 (2012-08-02) | 1-8,12, 13 | INV. H02J3/00 G01R31/00 H02H11/00 |
| A | * page 10, line 19 - page 15, line 23; claim 1; figures 1-4 * | 9-11 | |
| X | US 2014/247002 A1 (WILSON JEFFREY A [US] ET AL) 4 September 2014 (2014-09-04) | 1-8, 10-13 | |
| A | * paragraphs [0026] - [0031]; figure 6 * | 9 | |

TECHNICAL FIELDS
SEARCHED      (IPC)

H02J
G01R
H02H

The present search report has been drawn up for all claims

| Place of search | Date of completion of the search | Examiner |
|---|---|---|
| Munich | 9 January 2020 | Telega, Pawel |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 3 806 260 A1**

## ANNEX TO THE EUROPEAN SEARCH REPORT
## ON EUROPEAN PATENT APPLICATION NO.

EP 19 30 6316

This annex lists the patent family members relating to the patent documents cited in  the above-mentioned European search report.
The members are as contained in the European Patent Office EDP file on
The European Patent Office is in no way liable for these particulars which are merely given for the purpose of information.

09-01-2020

| Patent document cited in search report | | Publication date | Patent family member(s) | | Publication date |
|---|---|---|---|---|---|
| WO 2012101347 | A1 | 02-08-2012 | CN | 103339516 A | 02-10-2013 |
| | | | EP | 2668513 A1 | 04-12-2013 |
| | | | FR | 2970784 A1 | 27-07-2012 |
| | | | WO | 2012101347 A1 | 02-08-2012 |
| US 2014247002 | A1 | 04-09-2014 | CN | 104022600 A | 03-09-2014 |
| | | | US | 2014247002 A1 | 04-09-2014 |
| | | | US | 2016097575 A1 | 07-04-2016 |

EPO FORM P0459

For more details about this annex : see Official Journal of the European Patent Office, No. 12/82

22